# EUROPEAN PATENT APPLICATION

(11) **EP 1 017 085 A2**
(43) Date of publication of application: **05.07.2000**
(21) Application number: 00302162.3
(22) Date of filing: 24.03.2000
(51) Int. Cl.: H01L 21/00

(54) **Semiconductor device manufacturing apparatus employing vacuum system**

(30) Priority: 21.11.1995 KR 9542623
(62) Divisional of application: 96304288.2
(71) Applicant: SAMSUNG ELECTRONICS CO., LTD., Suwon-City, Kyungki-do (KR)
(72) Inventor: Jeon, Jae-sun, Suwon-city, Kyungki-do (KR); Yang, Yun-mo, Seoul (KR); Kim, Won-yeong, Kiheung-eub Yongin-city, Kyungki-do (KR); Chae, Seung-ki, Seoul (KR)
(74) Representative: Finnie, Peter John

(57) **Abstract**

A semiconductor device manufacturing apparatus employing a vacuum system is provided. The system has one or more of the following features. A heating source (81) is installed in a predetermined portion of a venting-gas inlet (71). A venting speed controlling valve (61) is installed in a predetermined portion of a venting pipe (51), for controlling the speed of gas flowing from a load lock chamber (21) to a pump (41) by control of the opening thereof. The venting pipe (51) has a main pipe of different diameters to reduce the venting speed. Condensation-induced particle formation is thus reduced by preventing adiabatic expansion of the gas in the load lock chamber (21).

## Description

The present invention relates to a semiconductor device manufacturing apparatus, and, more particularly, to a semiconductor device manufacturing apparatus employing a vacuum system. This application is a divisional application, divided from co-pending European Patent Application number 96304288.2.

In semiconductor device fabrication using a semiconductor device manufacturing apparatus employing a vacuum system, particles are formed during the pressure-reduction (pump down) of a process chamber and the formed particles settle on wafers being processed. Such particulate contamination of a semiconductor wafer significantly lowers the product yield and reliability of a semiconductor device. This problem becomes more severe with increasing wafer diameters and higher integration levels.

Particle formation during pressure-reduction or venting is attributed to a condensation mechanism caused by adiabatic expansion of gas (see "Condensation-Induced Particle Formation during Vacuum Pump Down" by Yan Ye et al., *Journal of the Electrochemical Society*, Vol. 140, No. 5, pp. 1463-1468, May 1993). According to the suggested mechanism, on a rapid drop in the pressure of a process chamber, gas in the chamber undergoes adiabatic expansion and its temperature falls rapidly. The gas is simultaneously condensed into water droplets. During the droplet formation, gases in the air such as SO₂, O₃, H₂O and other gaseous impurities diffuse into the droplets and are thus absorbed. Then, as the thermal capacity of the chamber walls is greater than that of the droplets, the inner surface temperature of the chamber decreases more slowly than that of the droplets. The resulting temperature difference causes heat to be transferred from the chamber to the droplets, leading to the heating and evaporation of the droplets, so that the concentration of impurities in the liquid increases. During the concentrated liquid phase, when the concentration of H₂O₂ in the liquid reaches a high enough level, H₂O₂ reacts quickly with SO₂ to form sulfuric acid, leading to the formation of sulfuric acid droplets. As the droplets continue to evaporate, residue particles which are spherical in shape are formed and which contain mainly sulfuric acid. The main elemental components of the residue particles are carbon, sulfur and oxygen, and the residue particles are quite stable thermodynamically. The residue particles thus do not evaporate completely even upon heating to temperatures as high as 180°C.

If the process chamber is smaller, the relative humidity of gas is higher and/or a depressurizing speed or a venting speed is higher, more condensation-induced particles are found.

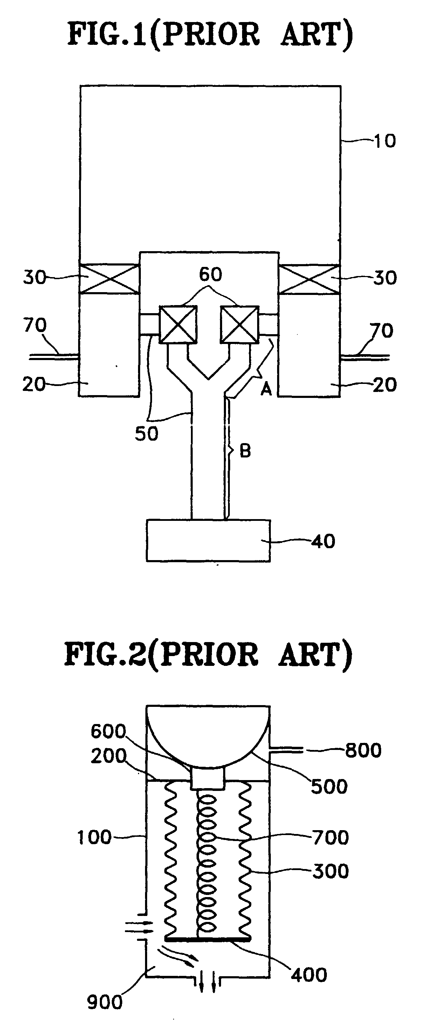

FIG. 1 is a schematic view of an ion-implanting apparatus in a conventional semiconductor device manufacturing apparatus employing a vacuum system. Here, a reference numeral 10 denotes a process chamber for ion-implanting a semiconductor wafer therein; reference numeral 20 denotes two load lock chambers, communicating with predetermined portions of the process chamber 10, for loading wafers to be transferred to the process chamber; reference numeral 30 denotes isolation valves installed between the process chamber 10 and each of the load lock chambers 20, for determining isolation of the process chamber 10 from the load lock chambers 20; reference numeral 40 denotes a pump for reducing the pressure of the load lock chambers 20 to transfer the wafers to the process chamber 10 in vacuum; reference numeral 50 denotes an venting pipe having two sub-pipes A connected to the respective load lock chambers 20 and a main pipe B of which one end is connected to the sub-pipes A and the other end is connected to the pump 40; and reference numeral 60 denotes shut-off valves installed in a predetermined portion of the sub-pipes A, for determining shut-off of the flow of gas from the load lock chambers 20 to pump 40.

In the device of FIG. 1, an air valve, which is opened and closed depending on gas pressure, is usually used as the shut-off valve 60. The diameter of the main pipe B is larger than that of the sub-pipes A, since gas flowing from the load lock chambers 20 is collected in and passes through the main pipe B. Also, reference numeral 70 denotes an inlet for injecting venting-gas into the load lock chambers 20.

The operation of the conventional semiconductor device manufacturing apparatus employing a vacuum system will now be described with reference to FIG. 1.

The venting pipe 50 installed between the shut-off valves 60 and pump 40 is maintained in a low vacuum of about 10⁻³Torr. Wafers are then loaded in the load lock chambers 20, and the shut-off valves 60 are opened to drop the pressure of the load lock chambers 20 to about 10⁻³ Torr. Thereafter, the wafers are transferred to the process chamber 10 by opening the isolation valves 30. Here, the process chamber 10 is at a high vacuum of about 10⁻⁶Torr.

The load lock chambers 20 are set to the lower vacuum so that a sudden turbulence of gas is prevented, and particles are preliminarily reduced before the wafers are transferred to the process chamber 10 by reducing the difference between the high vacuum of the process chamber 10 and the atmospheric pressure of the load lock chambers 20.

FIG. 2 is a sectional magnified view of the air valve 60 used as a shut-off valve. Here, a reference numeral 100 is a cylindrical case having orifices on the side and base thereof; reference numeral 200 denotes a board installed in a predetermined portion inside the case 100 to divide it into an upper part and a lower part and having a hole for communicating the lower part with the upper part in the center thereof; reference numeral 300 denotes a bellows fixed to the board 200 around the hole thereof to be sealed by the lower surface of the board and having an O-ring on the lower end portion thereof to open and close the base orifice of the case 100; reference numeral 500 denotes an elastic rubber boot installed on the internal upper surface of the case 100 and convex toward the lower part of the case 100; reference numeral 600 denotes a spring support fixed to the convex surface of the rubber boot 500, one portion thereof being inserted into the hole of the board 200; reference numeral 700 denotes a spring, one end of which is fixed to the base of the bellows 300 and whose other end is fixed to the spring support 600; reference numeral 800 denotes an air inlet communicating with a side of the upper part of the case 100, formed by the board 200; and reference numeral 900 denotes the flow of gas from the load lock chambers 20 to the pump 40 (FIG.1). If the pressure of air injected through the air inlet 800 is below a predetermined value, the lower orifice of the case 100 is closed by the bellows 400. If the air pressure is greater than or equal to the predetermined pressure, the convex end portion of the rubber boot 500 is pushed upward, vertically contracting the bellows 400 and thus opening the lower orifice of the case 100. Since the lower orifice is quickly opened, the pressure of the load lock chambers 20 also rapidly drops.

FIG. 3 shows scanning electron microspectroscopy (SEM) photographs of particles formed in the load lock chambers 20. The particles are about 0.3-3.7µm in diameter and spherical in shape.

FIG. 4 illustrates the result obtained by analyzing the components of the particles of FIG. 3 by Auger electron spectroscopy (AES). Here, the main components are shown to be sulfur, oxygen and carbon.

As described above, in the conventional semiconductor device manufacturing apparatus employing a vacuum system, gas condensation is found to be the cause of particle formation in an analysis of the shape and components of particles generated in the load lock chambers, as suggested by Yan Ye et al. In other words, as the shut-off valves installed on the venting pipe for exhausting the load lock chambers of gas are rapidly opened, the pressure of the load lock chambers drops quickly. Therefore, particle formation is attributed to adiabatic expansion of the gas in the load lock chambers.

By the same mechanism as above, the adiabatic expansion of venting-gas produces particles during the venting of the load lock chambers.

European Patent Application Number 0,385,709 discloses a fluid flow control method and apparatus for minimising particle contamination. The fluid flow is controlled to ensure that the flow rates are maintained at values which are not high enough to dislodge particulate contaminants from the chamber walls of the apparatus. European Patent Application Number 0,666,339 discloses a method of in-situ cleaning a throttle valve in a chemical vapour deposition device and an exhaust flow control apparatus for facilitating such cleaning. The cleaning is performed using a plasma which is ignited in a cleaning gas mixture of nitrogen triflouride, hexaflouroethane and oxygen.

The object of the present invention is to provide a semiconductor device manufacturing apparatus which can reduce condensation-induced particle formation by preventing adiabatic expansion of gas in a load lock chamber.

According to the present invention, there is provided a semiconductor device manufacturing apparatus comprising:
a process chamber for fabricating a semiconductor device therein;
a plurality of load lock chambers communicating with predetermined portions of said process chamber, for loading of semiconductor wafers to be transferred to said process chamber;
a pump for reducing the pressure of said plurality of load lock chambers;
a venting pipe connecting said load lock chambers with said pump, for exhausting gas from said load lock chambers, said venting pipe comprising a main pipe and a plurality of sub-pipes, wherein each sub-pipe has a first end connected to one of said plurality of load lock chambers, and a second end connected to said main pipe, and said main pipe having a first portion having a first diameter and a second portion having a second diameter larger than said first diameter, said first portion comprising an unbranched section of the main pipe extending from a point where the main pipe branches to connect to said plurality of sub-pipes, and the second portion comprising an unbranched section of the main pipe to a point where the main pipe connects to said pump and one or more valves installed in a predetermined portion of said venting pipe.

Specific embodiments of the present invention are described in detail below, by way of example, with reference to the attached drawings, in which:
FIG. 1 is a schematic view of a conventional semiconductor device manufacturing apparatus employing a vacuum system;
FIG. 2 is a sectional view of an air valve used as a shut-off valve of FIG. 1;

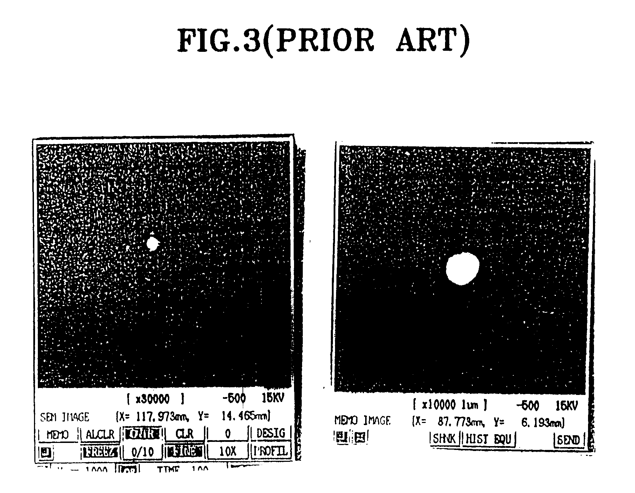

FIG. 3 shows SEM photographs of particles generated in the load lock chambers of FIG. 1;

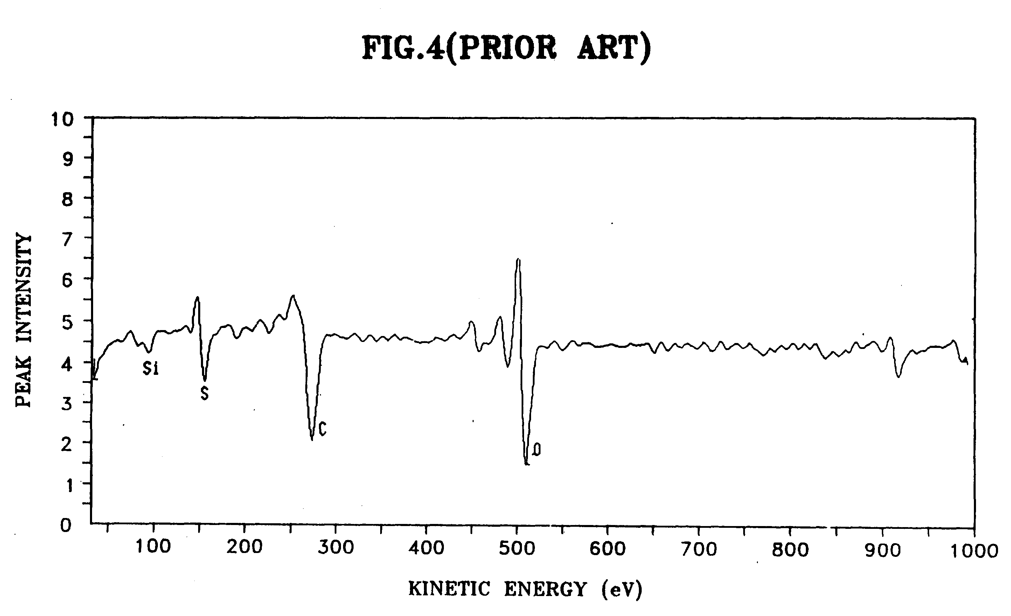

FIG. 4 shows the result from an AES analysis of the components of the particles of FIG. 3;

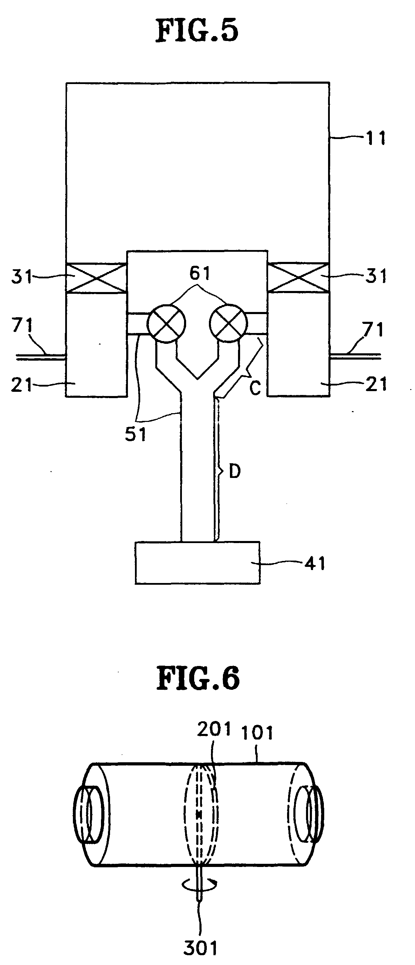

FIG. 5 is a schematic view of a semiconductor device manufacturing apparatus;
FIG. 6 is a schematic view of a throttle valve used as a venting speed controlling valve shown in FIG. 5;

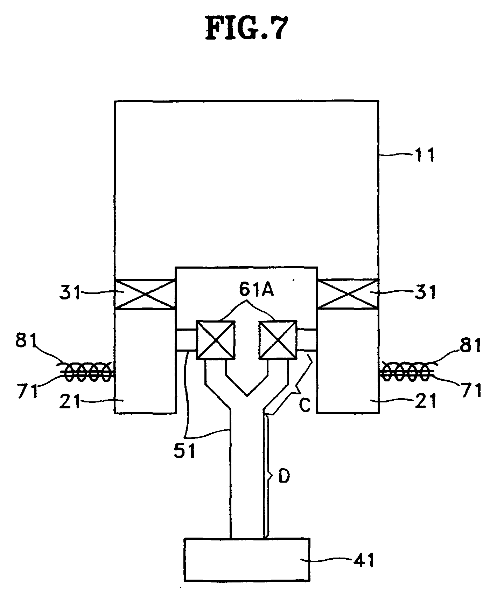

FIG. 7 is a schematic view of a semiconductor device manufacturing apparatus; and,

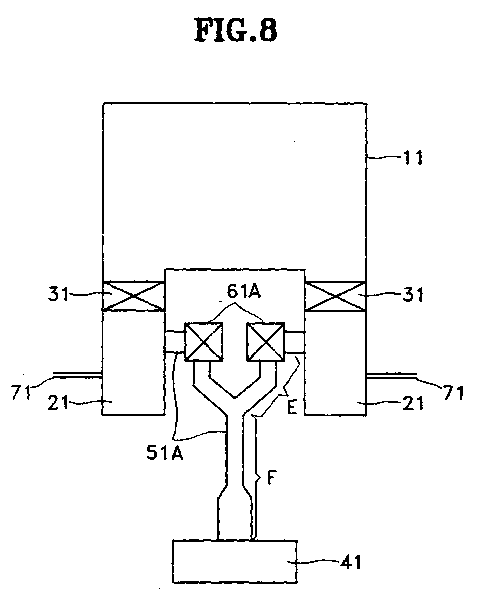

FIG. 8 is a schematic view of a semiconductor device manufacturing apparatus of the present invention.

FIG. 5 is a schematic view of a semiconductor device manufacturing apparatus, in particular an ion-implanting device. Here, a reference numeral 11 denotes a process chamber for ion-implanting a semiconductor wafer therein; reference numeral 21 denotes a plurality of, for example two, load lock chambers communicating with predetermined portions of the process chamber 11 for loading semiconductor wafers to be transferred to the process chamber; reference numeral 31 denotes isolation valves disposed between the process chamber 11 and each load lock chamber 21 of the process chamber 11 from the load lock chambers 21; reference numeral 41 denotes a pump for reducing the pressure of the load lock chambers 21 to enable transfer of the wafers from the load lock chambers 21 to the process chamber 11 in vacuum; reference numeral 51 denotes an venting pipe having a plurality (e.g., two) of sub-pipes C, each sub-pipe being connected to each load lock chamber 21, and a main pipe D, one end of which is connected to the sub-pipes C and whose other end is connected to pump 41; reference numeral 61 denotes a venting speed controlling valve installed to the venting pipe 51, for controlling the speed of the flow of gas from the load lock chambers 21 to the pump 41 by controlling the opening thereof; and reference numeral 71 denotes a venting-gas inlet for injecting venting-gas into each load lock chamber 21.

Preferably, the diameter of main pipe D is larger than that of the sub-pipes C, since gas flowing from the load lock chambers 21 is collected in and pass through the main pipe D. Further, a throttle valve may be used as the venting speed controlling valve 61.

Condensation-induced particle formation can be reduced by steadily increasing a venting speed with the venting speed controlling valve 61, and thus preventing adiabatic expansion of gas caused by a rapid drop of pressure of the load lock chambers 21. In addition, condensation-induced particle formation can also be reduced by providing a heating source, for example, a heater line in a predetermined portion of the venting gas inlet, to heat up gas injected during a venting process and thus reduce its relative humidity.

FIG. 6 is a schematic view of a throttle valve used as the venting-speed controlling valve 61. Here, a reference numeral 101 denotes a cylindrical case having orifices in the sides thereof, through which the cylindrical case 101 is connected to the venting pipe 51 of FIG. 5; reference numeral 201 denotes a disk-shaped rotational plate for dividing case 101 into left and right parts; and reference numeral 301 denotes a rotational shaft being rotated by a motor (not shown) and combined with the rotational plate 201 to vertically penetrate through the case 101 and pass through the center of the rotational plate 201. Thus, the rotational plate 201 is rotated by the rotation of the rotational shaft 301 with the rotational shaft as an axis, and the speed of gas flowing from the load lock chambers 21 to pump 41 (FIG. 5) depends on the degree of rotation.

FIG. 7 is a schematic view of a semiconductor device manufacturing apparatus, in particular an ion-implanting device. Like reference numerals denote the same elements as in FIG. 5. Reference numeral 61A denotes a shut-off valve installed in a predetermined portion of the sub-pipe C for shut-off of the flow of gas from the load lock chambers 21 to the pump 41. An air valve, for example, can be used as a shut-off valve. A reference numeral 81 denotes a heating source installed in a predetermined portion of the venting-gas inlet 71. A heating line, for example, can be used as the heating source. The heating source 81 heats up venting gas injected into the load lock chambers 21 to decrease the relative humidity of the venting gas, thereby reducing condensation-induced particle formation in the load lock chambers 21.

FIG. 8 is a schematic view of a semiconductor device manufacturing apparatus, in particular an ion-implanting device, according to the present invention. Like reference numerals denote the same elements as in FIG. 5. Reference numeral 51A denotes an venting pipe having a plurality of, for example two, sub-pipes E, and a main pipe F. Here, each sub-pipe is connected to a load lock chamber 21. The main pipe 21, of which one end is connected to the sub-pipes E and the other end is connected to the pump 41, has a first diameter for a predetermined length from the portion where the plurality of sub-pipes meet and has a second diameter in the other portion connected to the pump 41.

Preferably, the main pipe F has a first diameter for a predetermined length from where sub-pipes E meet, while it has a second diameter larger than the first diameter in the other portion thereof. The size of portion having the first diameter is exemplary, and the position of the first-diameter portion can be modified, if necessary. Further, the first diameter is larger than that of the sub-pipes E.

A reference numeral 61A denotes a shut-off valve installed in a predetermined portion of the sub-pipes E, for shut-off of the flow of gas from the load lock chambers 21 to the pump 41. An air valve can be used as the shut-off valve. The shut-off valves 61A are preferably installed in a predetermined portion of the sub-pipes E. Therefore, even where the shut-off valves 61A are suddenly opened, the speed of exhausted gas can be reduced due to the portion having the first diameter in the main pipe F. As a result, condensation-induced particle formation can be reduced by preventing adiabatic expansion of gas caused by a rapid drop in the pressure of the load lock chambers 21. In addition, condensation-induced particle formation can be also reduced by providing a heating source (not shown), for example, a heating line, in a predetermined portion of the venting-gas inlet to reduce the relative humidity of the venting gas.

As described above, according to the present invention, condensation-induced particle formation can be reduced by preventing adiabatic expansion of gas.

## Claims

1. A semiconductor device manufacturing apparatus comprising:
a process chamber (11) for fabricating a semiconductor device therein;
a plurality of load lock chambers (21) communicating with predetermined portions of said process chamber, for loading of semiconductor wafers to be transferred to said process chamber (11);
a pump (41) for reducing the pressure of said plurality of load lock chambers (21);
a venting pipe (51) connecting said load lock chambers (21) with said pump (41), for exhausting gas from said load lock chambers (21), said venting pipe (51) comprising a main pipe and a plurality of sub-pipes, wherein each sub-pipe has a first end connected to one of said plurality of load lock chambers (21), and a second end connected to said main pipe, and said main pipe having a first portion having a first diameter and a second portion having a second diameter larger than said first diameter, said first portion comprising an unbranched section of the main pipe extending from a point where the main pipe branches to connect to said plurality of sub-pipes, and the second portion comprising an unbranched section of the main pipe to a point where the main pipe connects to said pump (41) and one or more valves (21) installed in a predetermined portion of said venting pipe (51).

2. A semiconductor device manufacturing apparatus as claimed in claim 1, wherein said main pipe has a first diameter for the length of the first predetermined portion thereof and has a second diameter in the second portion, which is connected to said pump.

3. A semiconductor device manufacturing apparatus as claimed in claim 1 or claim 2, wherein said valve or valves (61A) are each installed in a predetermined portion of a sub-pipe.

4. A semiconductor device manufacturing apparatus as claimed in any of claims 1 to 3, wherein each of said load lock chambers (21) comprises:
a venting-gas inlet (71) for injecting venting gas into said load lock chamber; and
a heating source (81) installed in a predetermined portion of said venting-gas inlet.

5. A semiconductor device manufacturing apparatus as claimed in any of claims 1 to 4, wherein said one or more valves (61A) are shut-off valves.

6. A semiconductor device manufacturing apparatus as claimed in claim 5, wherein said shut-off valve or valves are air valves.
